# EUROPÄISCHE PATENTSCHRIFT

(11) **EP 3 158 837 B1**
(45) Veröffentlichungstag und Bekanntmachung des Hinweises auf die Patenterteilung: **05.08.2020**
(21) Anmeldenummer: 15728871.3
(22) Anmeldetag: 15.06.2015
(51) Int. Cl.: H05K 5/00, H05K 7/00, G06F 3/041, G06F 3/042, H04N 5/64

(54) **EIN- UND AUSGABEGERÄT MIT RAHMEN**
INPUT AND OUTPUT DEVICE HAVING A FRAME
PÉRIPHÉRIQUE D'ENTRÉE ET DE SORTIE COMPORTANT UN CADRE

(30) Priorität: 18.06.2014 AT 504262014
(43) Veröffentlichungstag der Anmeldung: 26.04.2017
(73) Patentinhaber: B&R Industrial Automation GmbH, 5142 Eggelsberg (AT)
(72) Erfinder: ESTERBAUER, Hermann, A-5121 Tarsdorf (AT); WIMMER, Johann, A-5144 Handenberg (AT)
(74) Vertreter: Patentanwälte Pinter & Weiss OG
(86) Internationale Anmeldenummer: PCT/EP2015/063336
(87) Internationale Veröffentlichungsnummer: WO 2015/193238

(56) Entgegenhaltungen:
- CN-U- 202 306 513
- CN-U- 202 306 514
- CN-U- 202 422 070
- CN-U- 202 496 007
- CN-U- 203 279 402
- CN-U- 203 393 093
- CN-Y- 2 555 529
- CN-Y- 201 131 097
- CN-Y- 201 255 876
- US-A1- 2006 061 256
- US-A1- 2009 262 512

## Beschreibung

Die gegenständliche Erfindung betrifft ein Ein- und Ausgabegerät für den industriellen Einsatz mit einem über den Umfang geschlossenen Rahmen mit einer zentralen durchgehenden Ausnehmung, in die eine Ein-Ausgabeeinheit eingesetzt ist, wobei der Rahmen aus einer Mehrzahl von einzelnen Rahmenteilen zusammengebaut ist, die zur Ausbildung des Rahmens an den Ecken miteinander verbunden sind, sowie ein Verfahren zum Herstellen eines solchen Rahmens und Ein- und Ausgabegerät.

Ein Großteil der modernen Ein- und Ausgabegeräte als Mensch-Maschine-Schnittstelle basiert auf Display- oder auch Touchscreen-Technologie als Ein- und Ausgabeeinheiten. Auch Tasten, Knöpfe, Schalter, etc. sind als Ein- und Ausgabeeinheiten weit verbreitet. Das gilt insbesondere und immer verstärkter auch für industrielle Anwendungen, wie z.B. die Steuerung von Maschinen und Anlagen. Aufgrund der steigenden Automatisierung sind entsprechende bildwiedergebende Ein- und Ausgabegeräte, wie z.B. Displays, Touchscreens, etc., an Werkzeug-, Bearbeitungs- und Verarbeitungsmaschinen, Schaltschränken, Überwachungs- und Steuerungseinheiten für Prozess- und Ablaufsteuerung und dergleichen weit verbreitet.

Gerade durch die Verwendung von Ein- und Ausgabegeräten im Zusammenhang mit der industriellen Nutzung sind die Ansprüche an derartige Geräte im industriellen Umfeld in Bezug auf mechanische Robustheit und Widerstandsfähigkeit gegenüber den äußeren Einflüssen und Gegebenheiten entsprechend gestiegen. Diese Anforderungen können in keiner Weise mit den Anforderungen an herkömmliche Ein- und Ausgabegeräten, insbesondere Displays wie sie z.B. im privaten Umfeld bei Monitoren und Fernsehgeräten vorkommen, verglichen werden.

Üblicherweise werden Ein- und Ausgabegeräte für den industriellen Einsatz ausgeführt, dass entsprechend stabile und widerstandsfähige Gehäuse bzw. Rahmen für diese Ein- und Ausgabegeräte vorgesehen werden. Aus diesem Grund werden Geräterahmen für industriell genutzte Ein- und Ausgabegeräte aus Metall, typischerweise aus Aluminium, gefertigt.

Daneben kann es noch Anforderungen an die Dichtheit der Ein- und Ausgabegeräte geben, da es im industriellen Umfeld oftmals Spritzwasser geben kann, gegen das das Display abgedichtet sein muss. Auch während der Reinigung einer Maschine oder Anlage, kann es zu einer Spritzwasserbelastung kommen, gegen die das Display zu schützen ist.

Gleichfalls werden oftmals auch Anforderungen hygienischer Natur gestellt. Hier geht es insbesondere darum, Möglichkeiten für eine Schmutzablagerung am Display weitestgehend zu unterbinden. Dabei sollen vor allem Rillen, Spalten und Vertiefungen am Display bzw. am Displayrahmen vermieden werden.

Um all diese Anforderungen erfüllen zu können, werden nach derzeitigem Stand der Technik Displays für industrielle Anwendungen mit einteiligen, das Display aufnehmenden Rahmen gefertigt.

Aufgrund der geringen Stückzahlen solcher Displays für den industriellen Einsatz, werden diese Rahmen nach heutigem Stand der Technik durch spanende Bearbeitung aus dem Vollen, beispielsweise durch Fräsen, gefertigt. Hierbei kommt es naturgemäß zu sehr hohen Materialverlusten, was die Kosten für solche Displayrahmen erhöht und auch die Fertigung aufwendig und ineffizient macht.

Grundsätzlich könnten solche einteiligen Displayrahmen auch im Druck- oder Spritzgussverfahren gefertigt werden, was sich aufgrund der Kleinstserien durch die hohen Werkzeugkosten (z.B. für Druckgussformen) aber kaum rechnet.

Das Dokument CN 202306514 U beschreibt ein Ultraschallschweißverfahren, das auf Molekular- und Grenzflächenreibung zwischen den zu verschweißenden Bauteilen basiert. Dazu werden die Bauteile mit einer Sonotrode zu hochfrequenten mechanischen Schwingungen angeregt, die ausreichend Reibungswärme erzeugt, um die Bauteile zu verschweißen. Ein Ultraschallverfahren benötigt daher zwingend direkten Kontakt zwischen den zu verschweißenden Bauteilen.

Aus der CN 2844970 Y ist ein Rahmen für ein LCD-Display bekannt, der aus einzelnen Rahmenteilen zusammengesetzt wird. Die Rahmenteile werden dabei aus einer Platte des Displaymaterials herausgeschnitten, zu einem Rahmen zusammengelegt und die flachen Rahmenteile werden an den Stoßstellen gefügt (Z.B. durch Löten, Schweißen oder Nieten). Danach werden die Ecken des flachen Rahmens ausgestanzt und die Seiten umgebogen, um einen Rahmen mit einem L-förmigen Querschnitt zu formen. Es ist offensichtlich, dass ein solcher Rahmen an den Ecken, an denen die umgebogenen Seiten aneinander liegen, nicht dicht sein kann. Ein solcher Rahmen ist daher für eine industrielle Anwendung ungeeignet.

Auch aus der KR 10 2005 0027375 A ist ein Rahmen für ein Flachdisplay bekannt, der aus einzelnen Rahmenteilen zusammengesetzt ist. Hier sind die Rahmenteile Plastikteile in Form von Pressteilen, die an den Stoßstellen verschweißt werden. Der Rahmen weist an den Ecken eine Ausnehmung aus, womit der Rahmen nicht dicht ausgeführt ist und daher nicht für den industriellen Einsatz geeignet ist.

Die US 2006/061256 A1 offenbart ein Anzeigegerät, das aus einem Bildschirm, einem dazwischen angeordneten Rahmen und einer Rückplatte besteht. Der Rahmen ist aus Rahmenteilen zusammengesetzt und besteht aus Glas. Die Rahmenteile sind an den Kontaktflächen mittels einer Glas-Fritte zusammengefügt. Der Rahmen ist allerdings nicht dafür geeignet, eine Ein-Ausgabeeinheit zur Anwendung im industriellen Umfeld einzusetzen.

Die Aufgabe der gegenständlichen Erfindung besteht daher darin, ein Ein- und Ausgabegerät für den industriellen Einsatz möglichst kostengünstig herzustellen, welches darüber hinaus den oben genannten Anforderungen im industriellen Umfeld gerecht wird.

Diese Aufgabe wird erfindungsgemäß dadurch gelöst, dass die Rahmenteile an den aneinanderstoßenden Verbindungsflächen durch eine Klebeverbindung stoffschlüssig gefügt sind, indem zwischen zwei aneinanderstoßenden Rahmenteilen ein ausgebildeter Klebespalt im Bereich von 0,05mm bis 0,2mm mit einem Kleber ausgefüllt ist und der Kleber als Fügemittel eine Fügeschicht ausbildet, die im Bereich einer äußeren Stirnseite und einer äußeren Umfangsfläche des Rahmens vollständig geschlossen ist, um eine vollständig geschlossene äußere Stirnseite des Rahmens und eine vollständig geschlossenen äußeren Umfangsfläche des Rahmens auszubilden. Da unterschiedlichste Profile in unterschiedlichsten Ausführungsformen für verschiedenste Anwendungsgebiete genutzt werden, sind diese weitläufig verfügbar und entsprechend kostengünstig. Da bei den üblichen Herstellungsvarianten für Profile, unabhängig von deren Material, kaum Abfall und/oder Ausschuss anfällt, kommt ein weiterer Kostenvorteil zum Tragen. Durch den nach außen vollständig geschlossenen Rahmen kann die in den Rahmen eingesetzte Ein- und Ausgabeeinheit entsprechend geschützt werden, wodurch die Anforderungen erfüllt werden können.

Das stoffschlüssige Fügen durch Kleben stellt eine kostengünstige Fügetechnik mit einer Reihe an Vorteilen dar. Zum einen erlauben solche Fügeverbindungen üblicherweise größere Toleranzen der Fügeteile, zum anderen kann die Fügeverbindung gleichzeitig als Dichtung wirken. Außerdem kann durch die Fügeverbindung auch eine ausreichende Stabilität des Rahmens sichergestellt werden. Nicht zuletzt sind stoffschlüssige Fügemethoden einfach und sicher zusteuern, was eine hohe Prozesssicherheit in der Fertigung der Rahmen nach sich zieht.

Das äußere Erscheinungsbild des Rahmens kann verbessert werden, wenn zumindest zwei aneinanderstoßende Rahmenteile zur Ausbildung der Verbindungsflächen an einer Ecke des Rahmens auf Gehrung geschnitten sind oder verzinkt sind. Darüber hinaus vereinfachen solche Verbindungsflächen auch das automatisierte, maschinelle Fertigen eines Rahmens.

Aus Hygienegründen ist es vorteilhaft, wenn aus der äußeren Stirnseite und/oder der äußeren Umfangsfläche nach dem Fügen vorstehendes Fügemittel durch Nachbearbeiten entfernt wird, um eine ebene äußere Stirnseite und/oder äußere Umfangsfläche zu erzielen. Damit kann sich daran kein Schmutz ablagen. Das gleiche kann erreicht werden, wenn über die äußere Stirnseite und/oder die äußere Umfangsfläche eine Abdeckfolie geklebt wird, die zumindest die Fügeschicht abdeckt, oder die äußere Stirnseite und/oder die äußere Umfangsfläche zumindest im Bereich der Fügeschicht lackiert oder beschichtet wird.

Die gegenständliche Erfindung wird nachfolgend unter Bezugnahme auf die Figuren 1 bis 6 näher erläutert, die beispielhaft, schematisch und nicht einschränkend vorteilhafte Ausgestaltungen der Erfindung zeigen. Dabei zeigt
Fig.1 ein erfindungsgemäßes Ein- und Ausgabegerät,
Fig.2 die Befestigung des erfindungsgemäßen Ein- und Ausgabegeräts an einer Trägerplatte,
Fig.3 eine Ansicht einer Verbindungsfläche an einem Rahmenteil aus einem Hohlprofil,
Fig.4 ein Schnitt durch eine Fügeschicht,
Fig.5 eine nachbearbeitete Fügeschicht und
Fig.6 eine Fügeschicht mit einer diese überdeckenden Abdeckung.

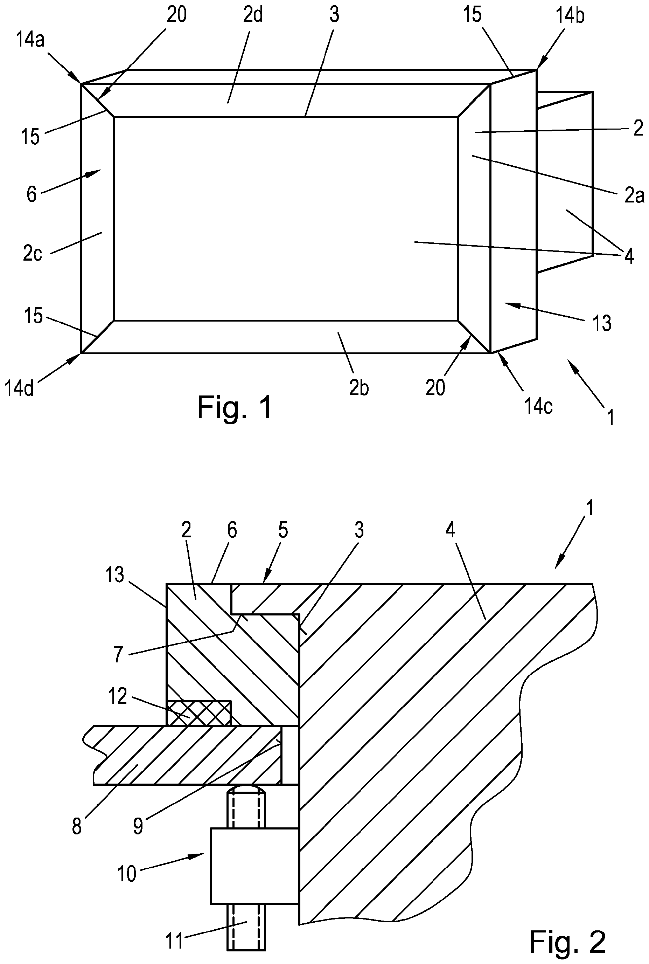

Fig.1 zeigt eine erfindungsgemäßes Ein- und Ausgabegerät 1 für ein industrielles Umfeld mit einem Rahmen 2 mit einer zentralen, axial durch den Rahmen 2 durchgehenden Ausnehmung 3, in die eine Ein- und Ausgabeeinheit 4, z.B. ein Display, ein Touchscreen, eine Einheit mit Tasten, Knöpfen oder Schaltern oder auch eine Kombination solcher Elemente, eingesetzt ist. Die Ein- und Ausgabeeinheit 4 kann auf verschiedenste Weise in das Ein- und Ausgabegerät 1 eingesetzt sein.

Im Ausführungsbeispiel nach Fig.2 weist die Ein- und Ausgabeeinheit 4 einen äußeren um den Umfang umlaufenden Umfangssteg 5 auf. Der Rahmen 2 hat an seiner äußeren Stirnseite 6, also die Stirnseite, die im betriebsgemäßen Einsatz des Ein- und Ausgabegerätes 1 sichtbar ist, eine zum Umfangssteg 5 komplementäre Umfangsnut 7, in der der Umfangssteg 5 zu liegen kommt. Vorzugsweise werden Umfangssteg 5 und Umfangsnut 7 dimensioniert, um eine bündig durchgehende äußere Stirnfläche des Ein- und Ausgabegeräts 1 zu erhalten, wie in Fig.2 angedeutet. Die Ein- und Ausgabeeinheit 4 kann zwischen Umfangssteg 5 und Umfangsnut 7 verklebt sein, um diese im Rahmen 2 zu fixieren. Zwischen Umfangsnut 7 und Umfangssteg 5 können auch geeignete Dichtelemente, wie z.B. O-Ringe, angeordnet sein. Es ist aber auch denkbar, die Ein- und Ausgabeeinheit 4 auf andere Weise am Rahmen 2 zu fixieren, z.B. durch Schraub-, Klemm-, Schnappverbindungen oder ähnliches. Ebenso ist es aber auch denkbar, dass die Ein- und Ausgabeeinheit 4 nur lose im Rahmen 2 eingesetzt und gehalten ist.

Das Ein- und Ausgabegerät 1 wird in der Regel in eine Montageausnehmung 9 einer Trägerplatte 8, z.B. an einem Schaltschrank oder einem Bedienteil einer Maschine, eingesetzt, wobei der Rahmen 2 an der Trägerplatte 8 anliegt und über den Rahmen 2 mit der Trägerplatte 8 verbunden wird, wie in Fig.2 gezeigt. Vorgesehen sein kann z.B. eine Klemmvorrichtung 10 an der Ein- und Ausgabeeinheit 4 in Form einer Schraube 11. Mittels der Schraube 11 kann der Rahmen 2 mit der Trägerplatte 8 verklemmt werden und damit das Ein- und Ausgabege-rät 1 fixiert werden. Ebenso kann zwischen Rahmen 2 und Trägerplatte 8 eine Dichtung 12 angeordnet sein, wie z.B. in der EP 2 590 489 A2 beschrieben.

Der Rahmen 2 wird aus einer Mehrzahl von einzelnen Rahmenteilen 2a, 2b, 2c, 2d, im Beispiel nach Fig.1 vier Rahmenteile, zusammengesetzt. Die Rahmenteile 2a, 2b, 2c, 2d sind bevorzugt aus auf die benötigte Länge abgelängten Profilen, z.B. aus Metall oder Kunststoff, gebildet. Die Profile können Voll- oder Hohlprofile mit im Wesentlichen beliebigen Querschnitt sein. Vorteilhaft ist vorgesehen, dass die Metall- oder Kunststoffprofile, welche die Rahmenteile 2a, 2b, 2c, 2d bilden, Strangpressprofile und/oder Strangziehprofile sind. Strangpressen stellt eine besonders kostengünstige und effiziente Herstellungstechnik für entsprechende Profile dar und ist aus diesem Grund weitläufig verbreitet. Solche Profile sind verhältnismäßig kostengünstig, schnell und in ausreichenden Mengen verfügbar.

Die Rahmenteile 2a, 2b, 2c, 2d sind an den Ecken 14a, 14b, 14c, 14d des Rahmens 2 miteinander verbunden. Hierzu können die Rahmenteile 2a, 2b, 2c, 2d, wie in Fig.1 gezeigt, an den Ecken14a, 14b, 14c, 14d des Rahmens 2 auf Gehrung geschnitten sein. Anstelle einer Gehrung können die Rahmenteile 2a, 2b, 2c, 2d, vor allem bei Vollprofilen, an den Ecken14a, 14b, 14c, 14d auch einfach auf Stoß aneinander gefügt sein. Ebenso ist es denkbar, dass die Rahmenteile 2a, 2b, 2c, 2d an den Ecken14a, 14b, 14c, 14d verzinkt sind.

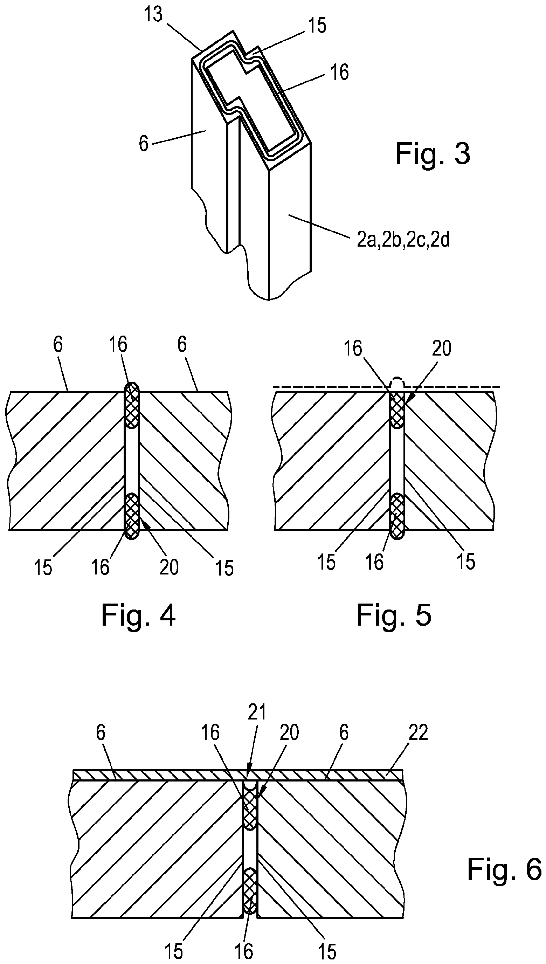

Jeweils zwei aneinander stoßende Rahmenteile 2a, 2b, 2c, 2d sind an deren entstehenden und einander zugewandten Verbindungsflächen 15 (Fig.3), z.B. Gehrungsflächen oder Verzinkungsflächen, erfindungsgemäß durch eine Klebeschicht stoffschlüssig miteinander verbunden, wodurch eine Fügeschicht 20 ausgebildet wird. Eine weitere zum Verbinden der Rahmenteile 2a, 2b, 2c, 2d in Frage kommende, nicht erfindungsgemäße Fügeverbindung wäre eine Schweißverbindung oder eine Lötverbindung.

Aufgrund der komplexen Querschnittsform des Rahmes 2, beispielsweise mit der Umfangsnut 7 und der Ausnehmung für die Dichtung 12, und der geringen Abmessungen ist der Fügeprozess fertigungstechnisch aufwendig, wenn die angestrebte Dichtheit und eine saubere Oberfläche erzielt werden soll. Der fertige Rahmen 2 muss für den industriellen Einsatz an der äußeren Stirnseite 6 des Rahmens 2 und an der äußeren Umfangsfläche 13 des Rahmens 2 vollständig geschlossen sein. Vollständig geschlossen bedeutet dabei, dass am Ein-und Ausgabegerät 1 kein Medium, wie z.B. Spritzwasser oder Reinigungsmittel, von außen in das Innere des Ein- und Ausgabegerätes 1 eindringen kann.

Durch die erfindungsgemäße Klebeverbindung wird zumindest auf eine Verbindungsfläche 15 aneinanderstoßender Rahmenteile 2a, 2b, 2c, 2d ein geeignetes Fügemittel 16 (Kleber) aufgebracht (Fig.3). Das Fügemittel 16 wird auf der Verbindungsfläche 15 vorzugsweise über den Umfang geschlossen appliziert. Das Fügemittel 16 wird aber zumindest so aufgetragen, dass die entstehende Fügeschicht 20 im Bereich der äußeren Stirnseite 6 und der äußeren Umfangsfläche 13 des Rahmens 2, also die im bestimmungsgemäßen Einsatz sichtbaren Flächen des Ein- und Ausgabegeräts 1, vollständig geschlossen ist, sodass sich an der äußeren Stirnseite 6 des Rahmens 2 und an der äußeren Umfangsfläche 13 des Rahmens 2 eine vollständig geschlossene Fläche ergibt und die entstehende Fügeschicht 20 insbesondere keine Löcher aufweist, durch die ein Medium, wie z.B. Spritzwasser oder Reinigungsmittel, von außen in das Innere des Rahmens 2 eindringen kann. Nach dem Aufbringen des Klebers werden die aneinanderstoßenden Rahmenteile 2a, 2b, 2c, 2d mit einer entsprechenden Vorrichtung aneinandergedrückt bis der Kleber allseitig herausquillt. Danach wird der Kleber ausgehärtet und die Klebestelle nachgearbeitet, um eine saubere Oberfläche zu erhalten. Dabei ist zumindest die äußere sichtbare Umfangsfläche 13 und Stirnseite 6 nachzubearbeiten, um eine saubere Oberfläche, insbesondere eine durchgehende Oberfläche ohne Ein- oder Ausbuchtungen, zu erhalten.

Dasselbe gilt in gleicher Weise im Falle einer nicht erfindungsgemäßen Löt- oder Schweißverbindung. Auch hier werden die Rahmenteile 2a, 2b, 2c, 2d derart gefügt, dass die entstehende Fügeschicht 20 im Bereich der äußeren Stirnseite 6 und der äußeren Umfangsfläche 13 des Rahmens 2, also die im bestimmungsgemäßen Einsatz sichtbaren Flächen des Ein-und Ausgabegeräts 1, vollständig geschlossen ist, sodass sich an der äußeren Stirnseite 6 des Rahmens 2 und an der äußeren Umfangsfläche 13 des Rahmens 2 eine vollständig geschlossene Fläche ergibt und die entstehende Fügeschicht 20 insbesondere keine Löcher aufweist, durch die ein Medium, wie z.B. Spritzwasser oder Reinigungsmittel, von außen in das Innere des Rahmens 2 eindringen kann. Bei einer Lötverbindung kann ebenfalls Lot an der Fügestelle vorstehen, das nachträglich zumindest teilweise entfernt werden kann, um eine sauberer Oberfläche auszubilden. Auch eine Schweißverbindung wird vorzugsweise zumindest teilweise nachzubearbeiten sein. Dabei ist zumindest die äußere sichtbare Umfangsfläche 13 und Stirnseite 6 nachzubearbeiten, um eine saubere Oberfläche, insbesondere eine durchgehende Oberfläche ohne Ein- oder Ausbuchtungen, zu erhalten.

Die Klebeverbindung kann vorzugsweise in einem Dünnschichtverfahren ausgeführt sein. Die entsprechenden Klebespalten zwischen den einzelnen Rahmenteilen 2a, 2b, 2c, 2d sind klein, vorteilhafterweise im Bereich von 0,05mm bis 0,2mm, vorzugsweise 0,1mm, und können durch den verwendeten Kleber sehr einfach vollständig ausgefüllt werden. Damit kann auch eine möglichst homogene Optik ohne sichtbare, äußere Defekte realisiert werden. Weiters ergeben sich bei richtiger Steuerung des Klebeverfahrens keine nennenswerten Unregelmäßigkeiten an der Oberfläche im Bereich der Fügung, wodurch auch das Anhaften von Verunreinigungen in diesem Bereich möglichst gering gehalten wird.

Im Idealfall wird das Fügemittel 16 so aufgetragen, dass das Fügemittel 16 weder aus der Stirnseite 6 (Umfangsfläche 13) hervortritt, noch eine Einbuchtung an dieser Stelle ausbildet.

Wie in Fig.4 dargestellt kann ein Fügemittel 16, wie z.B. ein Kleber oder Schmelzlot, etc., aber bewusst so aufgetragen werden, dass beim Zusammenbau der Rahmenteile 2a, 2b, 2c, 2d Fügemittel 16 an der Stirnseite 6, bzw. der Umfangsfläche 13, austritt und aus der Stirnseite 6, bzw. aus der Umfangsfläche 13 vorsteht. Wenn eine ebene äußere Stirnfläche 6, bzw. eine ebene äußere Umfangsfläche 13, gewünscht ist, dann kann der gefügte Rahmen 2 nach dem Fügen, also z.B. nach dem Verkleben und Aushärten des Klebers, auch nachbearbeitet, insbesondere spanend nachbearbeitet, werden, um den Überstand des Fügemittels 16 zu entfernen, wie in Fig.5 angedeutet. Es kann aber als Nachbearbeitung auch ausreichen, das überstehende Fügemittel 16 vor dem Aushärten zu entfernen, z.B. abzuwischen oder abzustreifen.

Das Fügemittel 16 kann aber auch so aufgetragen werden, dass das Fügemittel 16 beim Zusammenbau der Rahmenteile 2a, 2b, 2c, 2d nicht an der Stirnseite 6, bzw. der Umfangsfläche 13, austritt, sondern an dieser Stelle eine kleine Einbuchtung 21 verbleibt, wie in Fig.6 dargestellt. Werden an das Ein- und Ausgabegerät 1 Anforderungen an die Hygiene gestellt, kann eine solche Einbuchtung 21 unerwünscht sein. In diesem Fall kann vorgesehen sein, an der Stirnseite 6 und/oder an der Umfangsfläche 13 eine Abdeckung 22 vorzusehen, die zumindest die Fügeschicht 20 überdeckt. Die Abdeckung 22 kann beispielsweise als Abdeckfolie ausgeführt sein, die auf die Fläche aufgeklebt ist. Alternativ kann der stoffschlüssig gefügte Rahmen 2 an der äußeren Stirnseite 6 und/oder der Umfangsfläche 13 als Abdeckung 22 zumindest im Bereich der Fügeschicht 20, vorzugsweise vollständig, beschichtet werden, z.B. durch Pulverbeschichtung, oder lackiert werden.

Das Aufbringen einer Abdeckung 22, z.B. in Form einer Abdeckfolie, einer Beschichtung oder Lackierung, kann natürlich auch auf einem Rahmen wie in Fig.4 oder 5 dargestellt erfolgen. In diesem Fall könnte man sich unter Umständen auch das Nachbearbeiten des Rahmens 2 nach dem Fügen ersparen.

## Patentansprüche

1. Ein- und Ausgabegerät für den industriellen Einsatz mit einem über den Umfang geschlossenen Rahmen (2) mit einer zentralen durchgehenden Ausnehmung (3), in die eine Ein-Ausgabeeinheit (4) eingesetzt ist, wobei der Rahmen (2) aus einer Mehrzahl von einzelnen Rahmenteilen (2a, 2b, 2c, 2d) zusammengebaut ist, die zur Ausbildung des Rahmens (2) an den Ecken (14a, 14b, 14c, 14d) miteinander verbunden sind, **dadurch gekennzeichnet, dass** die Rahmenteile (2a, 2b, 2c, 2d) an den aneinanderstoßenden Verbindungsflächen (15) durch eine Klebeverbindung stoffschlüssig gefügt sind, indem zwischen zwei aneinanderstoßenden Rahmenteilen (2a, 2b, 2c, 2d) ein ausgebildeter Klebespalt im Bereich von 0,05mm bis 0,2mm mit einem Kleber ausgefüllt ist und der Kleber als Fügemittel (16) eine Fügeschicht (20) ausbildet, die im Bereich einer äußeren Stirnseite (6) und einer äußeren Umfangsfläche (13) des Rahmens (2) vollständig geschlossen ist, um eine vollständig geschlossene äußere Stirnseite (6) des Rahmens (2) und eine vollständig geschlossenen äußeren Umfangsfläche (13) des Rahmens (2) auszubilden.

2. Ein- und Ausgabegerät nach Anspruch 1, **dadurch gekennzeichnet, dass** zumindest zwei aneinanderstoßende Rahmenteile (2a, 2b, 2c, 2d) zur Ausbildung der Verbindungsflächen (15) an einer Ecke (14a, 14b, 14c, 14d) des Rahmens (2) auf Gehrung geschnitten oder verzinkt sind.

3. Ein- und Ausgabegerät nach einem der Ansprüche 1 bis 2, **dadurch gekennzeichnet, dass** aus der äußeren Stirnseite (6) und/oder der äußeren Umfangsfläche (13) nach dem Fügen vorstehendes Fügemittel (16) durch Nachbearbeiten entfernt ist, um eine ebene äußere Stirnseite (6) und/oder äußere Umfangsfläche (13) zu erzielen.

4. Ein- und Ausgabegerät nach einem der Ansprüche 1 bis 3, **dadurch gekennzeichnet, dass** über die äußere Stirnseite (6) und/oder die äußere Umfangsfläche (13) eine Abdeckfolie geklebt ist, die zumindest die Fügeschicht (20) abdeckt.

5. Ein- und Ausgabegerät nach einem der Ansprüche 1 bis 3, **dadurch gekennzeichnet, dass** die äußere Stirnseite (6) und/oder die äußere Umfangsfläche (13) zumindest im Bereich der Fügeschicht (20) lackiert oder beschichtet ist.

6. Verfahren zum Herstellen eines über den Umfang geschlossenen Rahmens (2) mit einer zentralen durchgehenden Ausnehmung (3) zum Einsetzen einer Ein-Ausgabeeinheit (4) eines Ein- und Ausgabegeräts (1) für den industriellen Einsatz, wobei der Rahmen (2) aus einer Mehrzahl von einzelnen Rahmenteilen (2a, 2b, 2c, 2d) zusammengebaut wird, die zur Ausbildung des Rahmens (2) an den Ecken (14a, 14b, 14c, 14d) miteinander verbunden werden, **dadurch gekennzeichnet, dass** die Rahmenteile (2a, 2b, 2c, 2d) an den aneinanderstoßenden Verbindungsflächen (15) mittels einer Klebeverbindung stoffschlüssig gefügt werden, indem zwischen zwei aneinanderstoßenden Rahmenteilen (2a, 2b, 2c, 2d) ein Klebespalt im Bereich von 0,05mm bis 0,2mm ausgebildet wird, der mit einem Kleber als Fügemittel (16) ausgefüllt und ausgehärtet wird, um eine Fügeschicht (20) auszubilden, die im Bereich einer äußeren Stirnseite (6) und einer äußeren Umfangsfläche (13) des Rahmens (2) vollständig geschlossen ist, um eine vollständig geschlossene äußere Stirnseite (6) des Rahmens (2) und eine vollständig geschlossenen äußeren Umfangsfläche (13) des Rahmens (2) auszubilden.

7. Verfahren nach Anspruch 6, **dadurch gekennzeichnet, dass** eine Fügestelle zur Ausbildung einer einwandfreien Oberfläche zumindest teilweise nachbearbeitet wird.

8. Verfahren nach Anspruch 7, **dadurch gekennzeichnet, dass** aus dem Klebespalt austretendes Fügemittel vor dem Aushärten entfernt wird.

9. Verfahren zum Herstellen eines Ein- und Ausgabegerätes (1) für den industriellen Einsatz mit einem über den Umfang geschlossenen Rahmen (2), der nach einem der Ansprüche 6 bis 8 hergestellt wird, wobei in die zentrale durchgehende Ausnehmung (3) des Rahmens (2) eine Ein-Ausgabeeinheit (4) eingesetzt wird.

## Claims

1. An input and output device for industrial use with a frame (2) which is sealed around the circumference with a continuous central recess (3) in which an input/output unit (4) is set in, wherein the frame (2) is assembled from a plurality of individual frame sections (2a, 2b, 2c, 2d) which are connected to one another at the corners (14a, 14b, 14c, 14d) in order to form the frame (2), **characterized in that** the frame sections (2a, 2b, 2c, 2d) are firmly bonded at the adjoining connecting surfaces (15) using a glued joint **in that** an adhesive gap in the range of 0.05 mm to 0.2 mm formed between two adjoining frame sections (2a, 2b, 2c, 2d) is filled with adhesive and the adhesive, as a joining agent (16), forms a bonding layer (20) which is fully sealed in the area of an external front face (6) and an external circumferential surface (13) of the frame (2) in order to form a fully sealed external front face (6) of the frame (2) and a fully sealed external circumferential surface (13) of the frame (2).

2. The input and output device according to claim 1, **characterized in that** at least two adjoining frame sections (2a, 2b, 2c, 2d) are mitred or dovetailed in order to form the connecting surfaces (15) at a corner (14a, 14b, 14c, 14d) of the frame (2).

3. The input and output device according to any of claims 1 to 2, **characterized in that** protruding joining agent (16) is removed from the external front face (6) and/or the external circumferential surface (13) through finishing after joining in order to achieve an even external front face (6) and/or external circumferential surface (13).

4. The input and output device according to any of claims 1 to 3, **characterized in that** a cover sheet which covers at least the bonding layer (20) is glued over the external front face (6) and/or the external circumferential surface (13).

5. The input and output device according to any of claims 1 to 3, **characterized in that** the external front face (6) and/or the external circumferential surface (13) is painted or coated at least in the area of the bonding layer (20).

6. A method for the production of a frame (2) which is sealed around the circumference with a continuous central recess (3) for setting in an input/output unit (4) of an input and output device (1) for industrial use, wherein the frame (2) is assembled from a plurality of individual frame sections (2a, 2b, 2c, 2d) which are connected to one another at the corners (14a, 14b, 14c, 14d) in order to form the frame (2), **characterized in that** the frame sections (2a, 2b, 2c, 2d) are firmly bonded at the adjoining connecting surfaces (15) using a glued joint **in that** an adhesive gap in the range of 0.05 mm to 0.2 mm is formed between two adjoining frame sections (2a, 2b, 2c, 2d), which is filled with an adhesive as a joining agent (16) and which is cured in order to form a bonding layer (20) which is fully sealed in the area of an external front face (6) and an external circumferential surface (13) of the frame (2) in order to form a fully sealed external front face (6) of the frame (2) and a fully sealed external circumferential surface (13) of the frame (2).

7. The method according to claim 6, **characterized in that** a joint is at least partially finished in order to form a flawless surface.

8. The method according to claim 7, **characterized in that** joining agent escaping from the adhesive gap is removed before curing.

9. A method for the production of an input and output device (1) for industrial use with a frame (2) which is sealed around the circumference, which is manufactured according to any of claims 6 to 8, wherein an input/output unit (4) is inserted into the continuous central recess (3) in the frame (2).

## Revendications

1. Périphérique d'entrée et de sortie à usage industriel, comportant un cadre qui est fermé circonférentiellement (2) et qui comporte un évidement continu central (3) dans lequel est insérée une unité d'entrée et de sortie (4), le cadre (2) étant constitué d'une pluralité de parties de cadre individuelles (2a, 2b, 2c, 2d) qui sont reliées les unes aux autres au niveau des coins (14a, 14b, 14c, 14d) pour former le cadre (2), **caractérisé en ce que** les parties de cadre (2a, 2b, 2c, 2d) sont jointes par liaison de matière au niveau des surfaces de liaison en butée (15) au moyen d'une liaison par collage en remplissant un espace de collage formé dans la plage de 0,05 à 0,2 mm avec une colle entre deux parties de cadre en butée (2a, 2b, 2c, 2d) et en formant, avec la colle, une couche de jonction (20) en tant que moyen de jonction (16), laquelle couche de jonction est complètement fermée au niveau d'une face frontale externe (6) et d'une surface périphérique externe (13) du cadre (2) afin de former une face frontale externe complètement fermée (6) du cadre (2) et une surface périphérique externe complètement fermée (13) du cadre (2).

2. Périphérique d'entrée et de sortie selon la revendication 1, **caractérisé en ce qu'au** moins deux parties de cadre en butée (2a, 2b, 2c, 2d) destinées à former les surfaces de liaison (15) sont coupées à onglet ou galvanisées au niveau d'un coin (14a, 14b, 14c, 14d) du cadre (2).

3. Périphérique d'entrée et de sortie selon l'une des revendications 1 à 2, **caractérisé en ce que** le moyen de jonction (16) dépassant de la face frontale externe (6) et/ou de la surface périphérique externe (13) après la jonction est éliminé par traitement ultérieur afin d'obtenir une face frontale externe (6) plane et/ou une surface périphérique externe (13) plane.

4. Périphérique d'entrée et de sortie selon l'une des revendications 1 à 3, **caractérisé en ce qu'un** film de recouvrement est collé sur la face frontale externe (6) et/ou sur la surface circonférentielle externe (13), lequel film de recouvrement recouvre au moins la couche de jonction (20).

5. Périphérique d'entrée et de sortie selon l'une des revendications 1 à 3, **caractérisé en ce que** la face frontale externe (6) et/ou la surface périphérique externe (13) sont laquées ou revêtues au moins dans la zone de la couche de jonction (20).

6. Procédé de réalisation d'un cadre (2) qui est fermé circonférentiellement et qui comporte un évidement central continu (3) destiné à l'insertion d'une unité d'entrée et de sortie (4) d'un périphérique d'entrée et de sortie (1) à usage industriel, le cadre (2) étant constitué d'une pluralité de parties de cadre individuelles (2a, 2b, 2c, 2d) qui sont reliées les unes aux autres pour former le cadre (2) au niveau des coins (14a, 14b, 14c, 14d), **caractérisé en ce que** les parties de cadre (2a, 2b, 2c, 2d) sont jointes par liaison de matière au niveau des surfaces de liaison en butée (15) au moyen d'une liaison par collage en formant un espace de collage dans la plage de 0,05 à 0,2 mm entre deux parties du cadre en butée (2a, 2b, 2c, 2d), lequel espace de collage est rempli d'une colle en tant que moyen de jonction (16) et est durci pour former une couche de jonction (20), laquelle couche de jonction est complètement fermée dans la zone d'une face frontale externe (6) et d'une surface périphérique externe (13) du cadre (2) afin de former une face frontale externe complètement fermée (6) du cadre (2) et une surface périphérique externe complètement fermée (13) du cadre (2).

7. Procédé selon la revendication 6, **caractérisé en ce qu'un** point de jonction est au moins partiellement traité ultérieurement pour former une surface uniforme.

8. Procédé selon la revendication 7, **caractérisé en ce que** le moyen de jonction dépassant de l'espace de collage est éliminé avant le durcissement.

9. Procédé de réalisation d'un périphérique d'entrée et de sortie (1) à usage industriel, le périphérique comportant un cadre (2) fermé circonférentiellement, lequel cadre est réalisé selon l'une des revendications 6 à 8, une unité d'entrée et de sortie (4) étant insérée dans l'évidement central continu (3) du cadre (2).
